# EUROPEAN PATENT SPECIFICATION

(11) **EP 3 038 223 B1**
(45) Date of publication and mention of the grant of the patent: **04.04.2018**
(21) Application number: 15199762.4
(22) Date of filing: 14.12.2015
(51) Int. Cl.: H02H 3/00, H02M 1/08, H02M 1/34, H03K 17/0814

(54) **LOAD DRIVING CIRCUIT**
LASTTREIBERSCHALTUNG
CIRCUIT DE COMMANDE DE CHARGE

(30) Priority: 25.12.2014 JP 2014261586
(43) Date of publication of application: 29.06.2016
(73) Proprietor: SANKEN ELECTRIC CO., LTD., Niiza-shi, Saitama 352-8666 (JP)
(72) Inventor: OZONO, Yuta, Niiza-shi, Saitama 352-8666 (JP)
(74) Representative: Grünecker Patent- und Rechtsanwälte PartG mbB

(56) References cited:
- JP-A- 2013 016 959
- US-A1- 2010 027 176
- US-A1- 2012 187 934
- US-A1- 2014 217 959

## Description

### TECHNICAL FIELD

The present invention relates to a load driving circuit configured to drive a load, such as a solenoid, by using a switching element.

### BACKGROUND ART

A known conventional load driving circuit is described in Japanese Unexamined Patent Application Publication No. 2013-16959. The load driving circuit detects a load open state in which a load is not connected to an output terminal because of some factor such as a break of wiring connecting the output terminal to the load.

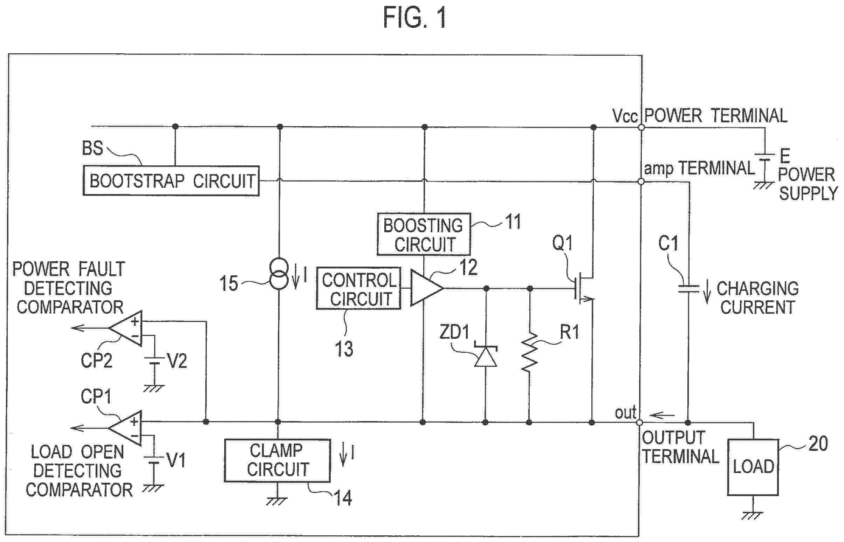

As illustrated in FIG. 1, a load driving circuit includes a switching element Q1 formed of a MOSFET, a first comparator CP1, a second comparator CP2, and a clamp circuit 14. The first comparator CP1 compares an output voltage Vout of an output terminal OUT with a first reference voltage V1 that is lower than a voltage of a power supply E, which is inputted to a power terminal Vcc. The first comparator CP1 then outputs H level when the output voltage Vout is equal to or more than the first reference voltage V1, to detect the load open state.

The second comparator CP2 compares the output voltage Vout of the output terminal OUT with a second reference voltage V2 that is lower than the voltage of the power supply E and higher than a voltage Vclamp. The second comparator CP2 then outputs H level when the output voltage Vout is equal to or more than the second reference voltage V2 to detect a power fault state.

In the load open state where the switching element Q1 is off and a load 20 is not connected to the output terminal OUT, the clamp circuit 14 clamps the voltage of the output terminal OUT to a clamp voltage that is higher than the first reference voltage V1 and lower than the voltage of the power supply E.

In the above configuration, in a case where the load is put into the load open state, when the switching element Q1 is turned off, the clamp circuit 14 clamps the output voltage Vout to the clamp voltage.

Since the first reference voltage V1 of the first comparator CP1 is set such that GND < V1 < Vclamp, the first comparator CP1 can detect the load open state. On the other hand, since the second reference voltage V2 of the second comparator CP2 is set such that Vclamp < V2 < E, the second comparator CP2 does not detect power fault. The power fault refers to the state where the output terminal OUT is wrongly connected to the power supply E for some reason.

In the power fault state, even when the switching element Q1 is off, the voltage of the output terminal OUT rises to the voltage of the power supply E. At this time, since the first reference voltage V1 of the first comparator CP1 is set such that GND <V1 < Vclamp, the first comparator CP1 detects this state as the load open state. Since the second reference voltage V2 is set such that Vclamp < V2 < E, the second comparator CP2 can detect this state as the power fault state

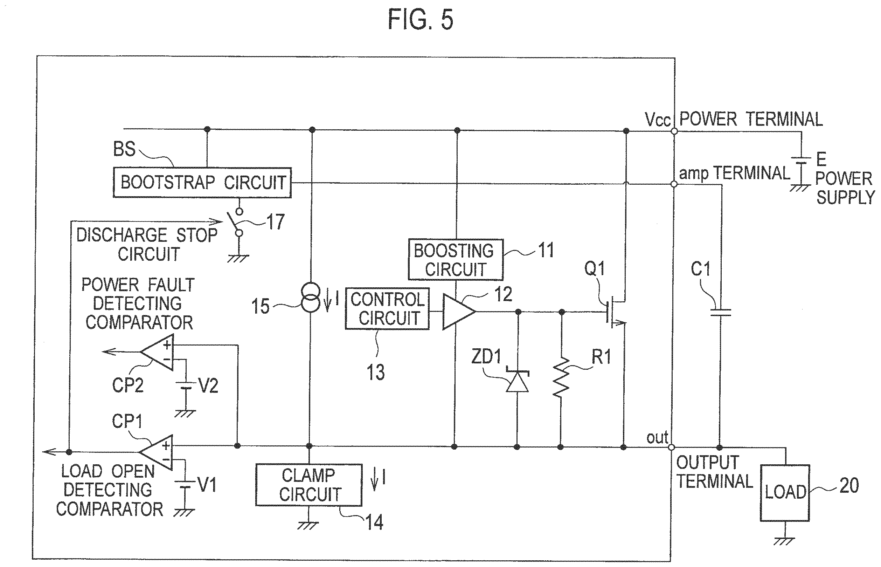

In the case of using a N-type MOSFET as a high-side transistor of the output switching element Q1, a bootstrap circuit BS is added as illustrated in FIG. 5.

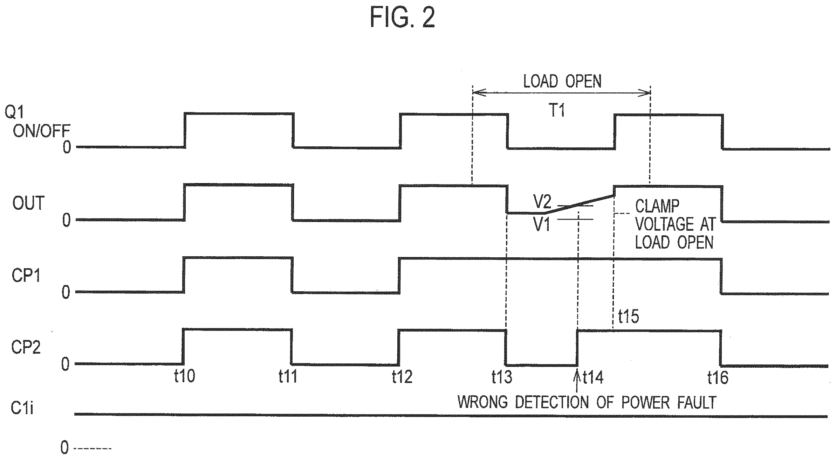

However, when the bootstrap circuit BS is added and the load is put into the load open state, a following problem occurs. This problem will be described with reference to FIG. 2. In FIG. 2, Q1_{ON/OFF} denotes an ON/OFF signal of the switching element Q1, OUT denotes an output voltage, CP1 denotes an output of the first comparator CP1, CP2 denotes an output of the second comparator CP2, and Cli denotes a charging current flowing through a capacitor C1.

When the load is put into the load open state during a period T1, a current flows from the bootstrap circuit BS to a resistor in the clamp circuit 14 via the capacitor C1. Thus, the voltage largely drops due to the resistor in the clamp circuit 14, the clamp voltage Vclamp, that is, the output voltage OUT rises, and the output voltage OUT becomes the second reference voltage V2 at a time t14. For this reason, the second comparator CP2 outputs H level. In other words, the power fault state is wrongly detected even though the state is not actually the power fault state.

US 2014/217959 A1 discloses a synchronous switching converter that converts a DC input voltage into a DC output voltage. This synchronous switching converter includes a high-side switching MOSFET coupled between an input node and a first node. The converter also includes a low-side switching MOSFET coupled between the first node and a ground node and is in series with the high-side switching MOSFET. This converter additionally includes a bootstrap capacitor coupled to the high-side switching MOSFET to provide turn-on voltage for the high-side switching MOSFET. Furthermore, the converter includes a main refresh circuit coupled to the bootstrap capacitor and is configured to refresh the bootstrap capacitor during a first operating mode of the synchronous switching converter. Moreover, the converter includes an auxiliary refresh circuit coupled to the main refresh circuit and the bootstrap capacitor and is configured to refresh the bootstrap capacitor during a second operating mode of the converter.

US 2012/187934 A1 discloses a DC-DC converter which includes: a high-side MOSFET as a main switching element which is driven by using a bootstrap capacitor; a low-side MOSFET as a synchronous rectifier, wherein a series circuit of the high-side MOSFET and the low-side MOSFET is connected to a DC power supply; and a coil and a smoothing capacitor, which are serially connected between the drain and the source of the low-side MOSFET; an overvoltage protection unit, which clamps an overvoltage; an overcurrent interrupting unit, which interrupts an overcurrent that flows when the overvoltage protection unit clamps the overvoltage; and a protection circuit, wherein the protection circuit includes a differential-voltage detecting unit detecting the voltage of both ends of the bootstrap capacitor, and a control unit that, when the voltage detected by the differential-voltage detecting unit exceeds a predetermined value, turns OFF the low-side MOSFET and turns ON the high-side MOSFET.

US 2010/027176 A1 relates to an arc fault detection apparatus that provides for better discrimination of electrical arcing events from nuisance loads. The arc fault detection apparatus includes an arcing sense circuit having a comparator circuit with a variable threshold voltage that varies continuously with the line voltage. The arc fault detection apparatus has reduced susceptibility to nuisance tripping in the presence of sudden changes in the load current that occur outside of a specified time window centered on each zero crossing point of the line voltage.

An object of the present invention is to provide a load driving circuit capable of preventing wrong detection of the power fault state when a bootstrap circuit is connected.

### SUMMARY OF THE INVENTION

A load driving circuit in accordance with the present invention, as set forth in claim 1, including: a first terminal connected to a power supply; a second terminal connected to a load; a switching element connected between the first terminal and the second terminal; a first comparator configured to compare a voltage of the second terminal with a first reference voltage that is lower than an input voltage inputted to the first terminal to detect a load open state where the switching element is off and the load is not connected to the second terminal; a clamp circuit configured to clamp the voltage of the second terminal to a clamp voltage that is higher than the first reference voltage and lower than the input voltage, in the load open state; a second comparator configured to compare the voltage of the second terminal with a second reference voltage that is lower than the input voltage and higher than the clamp voltage to detect a power fault state where the switching element is off and the second terminal is connected to the power supply; a capacitor having one end connected to the second terminal and another end connected to a third terminal; and a bootstrap circuit configured to generate a constant voltage based on a voltage of the power supply at the first terminal, and to feed a charging current to the third terminal at the constant voltage; characterized in that the load driving circuit further comprises a clamp voltage rise suppressing circuit configured to suppress a rise in the clamp voltage of the clamp circuit when the first comparator detects the load open state.

Meanwhile, a load driving circuit in accordance with the present invention, as set forth in claim 4, includes: a first terminal connected to a power supply; a second terminal connected to a load; a switching element connected between the first terminal and the second terminal; a first comparator configured to compare a voltage of the second terminal with a first reference voltage that is lower than an input voltage inputted to the first terminal to detect a load open state where the switching element is off and the load is not connected to the second terminal; a clamp circuit configured to clamp the voltage of the second terminal to a clamp voltage that is higher than the first reference voltage and lower than the input voltage, in the load open state; a second comparator configured to compare the voltage of the second terminal with a second reference voltage that is lower than the input voltage and higher than the clamp voltage to detect a power fault state; a capacitor having one end connected to the second terminal and another end connected to a third terminal; and a bootstrap circuit configured to generate a constant voltage based on a voltage of the power supply at the first terminal, and to feed a charging current to the third terminal at the constant voltage, characterized in that when the first comparator detects the load open state, the second comparator sets the second reference voltage to a voltage that is higher than a voltage generated by a current including a current flowing from the bootstrap circuit to the clamp circuit via the third terminal and the capacitor, and lower than the input voltage.

### EFFECT OF THE INVENTION

According to the present invention, when the first comparator detects the load open state, the clamp voltage rise suppressing circuit suppresses a rise in the clamp voltage of the clamp circuit. Further, when the first comparator detects the load open state, the second reference voltage is set to a voltage that is higher than a voltage generated by a current including a current flowing from the bootstrap circuit to the clamp circuit via the third terminal and the capacitor, and lower than the input voltage. Therefore, according to the present invention, wrong detection of the power fault state can be prevented.

### BRIEF DESCRIPTION OF DRAWINGS

FIG. 1 is a diagram illustrating a configuration of a conventional load driving circuit.
FIG. 2 is a chart illustrating operational waveforms of units of the conventional load driving circuit.
FIG. 3 is a diagram illustrating a configuration of a load driving circuit in accordance with Embodiment 1 of the present invention.
FIG. 4 is a chart illustrating operational waveforms of units of the load driving circuit in accordance with Embodiment 1 of the present invention.
FIG. 5 is a diagram illustrating a configuration of a load driving circuit in accordance with Embodiment 2 of the present invention.
FIG. 6 is a diagram illustrating a configuration of a load driving circuit in accordance with Embodiment 3 of the present invention.

### DESCRIPTION OF EMBODIMENTS

Load driving circuits in accordance with embodiments of the present invention will be described below in detail with reference to figures. Note that the same components as those in the conventional load driving circuit illustrated in FIG. 1 are given the same reference numerals.

### (Embodiment 1)

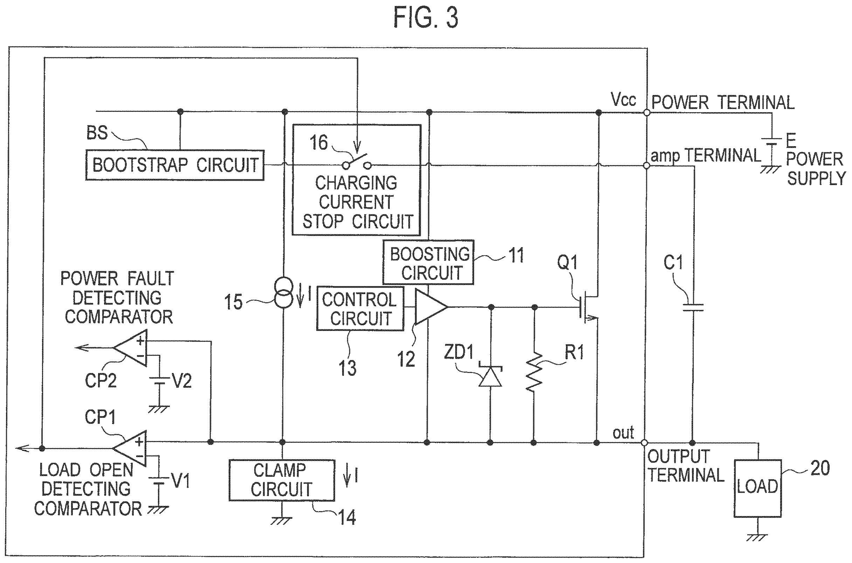

FIG. 3 is a diagram illustrating a configuration of a load driving circuit in accordance with Embodiment 1 of the present invention. The load driving circuit illustrated in FIG. 3 includes a power terminal Vcc, a switching element Q1, a boosting circuit 11, a buffer circuit 12, a control circuit 13, an output terminal OUT, a clamp circuit 14, a constant current circuit 15, a first comparator CP1, a second comparator CP2, a bootstrap circuit BS, and a charging current stop circuit 16, and drives a load 20 connected to the output terminal OUT with electric power inputted from a power supply E connected to the power terminal Vcc.

The switching element Q1 turns ON/OFF the power feeding path from the power terminal Vcc to the output terminal OUT, thereby controlling the current flowing to the load 20. The switching element Q1 consists of an MOSFET as a high-side switch, a drain of the switching element Q1 is connected to the power terminal Vcc, and a source of the switching element Q1 is connected to the output terminal OUT. Incidentally, a bipolar transistor may be used as the switching element Q1.

Further, a resistor R1 and a gate protection-constant voltage diode ZD1 are connected in parallel between the gate and the source of the switching element Q1. The switching element Q1, the resistor R1, the gate protection-constant voltage diode ZD1, the buffer circuit 12, and the clamp circuit 14 constitute a high-side drive circuit.

The control circuit 13 is connected to the boosting circuit 11 via the buffer circuit 12, and outputs a control signal for controlling turning ON/OFF of the switching element Q1. The control circuit 13 boosts the control signal to a voltage that is higher than the voltage E by the boosting circuit 11 configured to boost the voltage E, and applies the boosted control signal to the gate of the switching element Q1 to control turning ON/OFF of the switching element Q1.

The constant current circuit 15 is connected between the power terminal Vcc and the output terminal OUT in parallel with the switching element Q1, and passes a constant current I that is not enough to drive the load 20 (for example, a few dozen pA to 100µA).

The clamp circuit 14 has an impedance that is ten times or more, preferably, hundred times or more of an impedance of the load 20, and is connected in parallel with the load 20. When the switching element Q1 is off in the load open state, the constant current I is passed from the constant current circuit 15 to only the clamp circuit 14.

Accordingly, the clamp voltage is determined based on the constant current I passed from the constant current circuit 15 and the impedance of the clamp circuit 14, and becomes higher than a ground potential and lower than the voltage E. Incidentally, when the switching element Q1 is off and in the non-load open state, most of the constant current I passed from the constant current circuit 15 flows through the load 20, and the voltage Vout of the output terminal OUT becomes about the ground potential.

Functions of the first comparator CP1 and the second comparator CP2 are the same as those illustrated in FIG. 1 and thus, description thereof is omitted.

The capacitor C1 is a bootstrap capacitor, one end of which is connected to the output terminal OUT, and the other end of which is connected to an amp terminal. The bootstrap circuit BS has a constant voltage circuit configured to generate a constant voltage based on the voltage E of the power supply at the power terminal Vcc, and feeds a charging current to the amp terminal at the constant voltage. Note that, in this embodiment, the bootstrap circuit BS and the capacitor C1 constitute a bootstrap circuit.

The charging current stop circuit 16 is provided between the bootstrap circuit BS and the amp terminal. The charging current stop circuit 16 is formed of a switch, and constitutes a clamp voltage rise suppressing circuit configured to suppress a rise in the clamp voltage of the clamp circuit 14 when the first comparator CP1 detects the load open state.

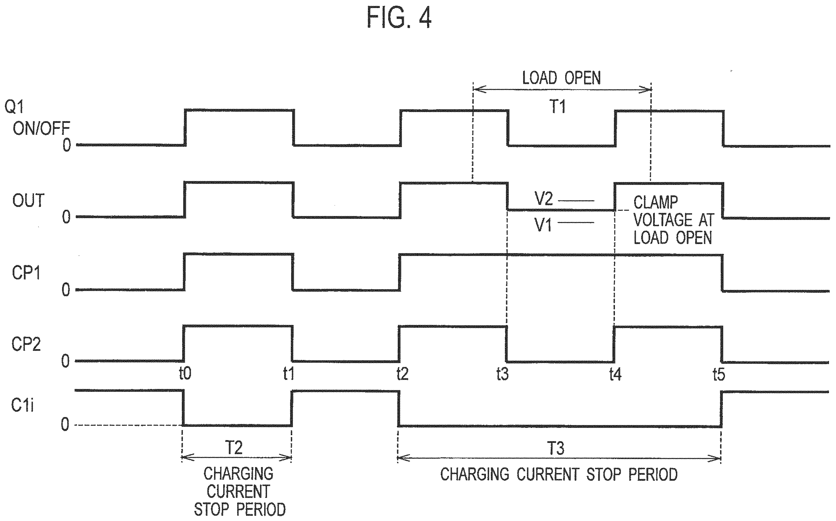

Next, the operation of the load driving circuit thus configured of Embodiment 1 will be described in detail with reference to FIG. 4.

First, during normal operation, that is, in the non-load open state and non-power fault state, when the switching element Q1 is turned on, a current flows through the load 20, and the voltage Vout of the output terminal OUT becomes the input voltage E. During normal operation, when the switching element Q1 is turned off, most of the constant current I passed from the constant current circuit 15 flows through the load 20.

Accordingly, when the switching element Q1 is off, the voltage Vout of the output terminal OUT becomes almost the ground potential, and falls below both of the reference voltage V1 and the reference voltage V2. As a result, both of the outputs of the first comparator CP1 and the second comparator CP2 become L level, and the load open state and the power fault state are not detected.

Even in the load open state, when the switching element Q1 is turned on, the voltage Vout of the output terminal OUT becomes the voltage E.

Next, in the load open state, when the switching element Q1 is off, the constant current I of the constant current circuit 15 flows to the clamp circuit 14, and the clamp circuit 14 clamps the voltage Vout of the output terminal OUT to the clamp voltage. Accordingly, when the switching element Q1 is off, the voltage Vout of the output terminal OUT exceeds the reference voltage V1. As a result, the output of the first comparator CP1 becomes H level, and the load open state is detected.

When the first comparator CP1 outputs a load open state detection signal to the charging current stop circuit 16, the switch of the charging current stop circuit 16 is turned off to stop feeding of the charging current from the bootstrap circuit 10 to the capacitor C1. Thus, the clamp voltage Vclamp of the clamp circuit 14 is not increased by the charging current from the bootstrap circuit 10.

Accordingly, since the clamp voltage Vclamp cannot exceed the second reference voltage V2, the second comparator CP2 outputs L level. This can prevent wrong detection of the power fault state.

In the power fault state, the clamp voltage becomes the voltage E. Thus, since the voltage E is inputted to a non-inverting terminal of the second comparator CP2, and the voltage Vclamp is inputted to an inverting terminal of the second comparator CP2, the second comparator CP2 outputs H level. This can detect the power fault state.

FIG. 4 is a chart illustrating operational waveforms of units of the load driving circuit in accordance with Embodiment 1 of the present invention. As illustrated in FIG. 4, during normal operation, feeding of the charging current to the capacitor C1 is stopped in a period from time t0 to time t1 (charging current stop period T2), and the charging current is passed to the capacitor C1 in a period from time t1 to time t2.

However, in time period T1 including a period from t3 to time t4 when the charging current should be passed to the capacitor C1, in the case of load open state, feeding of the charging current from the bootstrap circuit 10 is stopped by turning off the switch of the charging current stop circuit 16 in the period from time t3 to time t4. This can keep the voltage of the output terminal OUT, that is, the clamp voltage, at the constant voltage.

### (Embodiment 2)

FIG. 5 is a diagram illustrating a configuration of a load driving circuit in accordance with Embodiment 2 of the present invention. The load driving circuit in accordance with Embodiment 2 in FIG. 5 is characterized by providing a discharge stop circuit 17 in place of the charging current stop circuit 16 of the load driving circuit in Embodiment 1 illustrated in FIG. 3.

Other configuration is the same as that of the load driving circuit in Embodiment 1 and thus, description thereof is omitted.

The discharge stop circuit 17 is formed of a switch connected between the bootstrap circuit BS and the ground, and discharging of a current flowing from the capacitor C1 to the ground via the bootstrap circuit BS is stopped by turning off the switch when the first comparator CP1 detects the load open state.

The operation of the load driving circuit thus configured in Embodiment 2 will be described. The operation during normal operation and in the load open state is the same as that of the load driving circuit in Embodiment 1 and thus, only the operation in the case where the switching element Q1 is off and the first comparator CP1 detects the load open state will be described.

First, discharging from the capacitor C1 to the ground starts, lowering the output of the amp terminal. Then, the constant voltage circuit of the bootstrap circuit BS attempts to pass the current to the amp terminal to output a constant voltage.

However, when the current flows to the capacitor C1 via the amp terminal, the voltage of the clamp circuit 14 rises. As a result, the voltage of the clamp circuit 14 becomes equal to or more than the first reference voltage V1, and the first comparator CP1 outputs H level to the switch of the discharge stop circuit 17.

Thus, the switch of the discharge stop circuit 17 is turned off to stop a discharging current flowing from the capacitor C1 to the ground via the bootstrap circuit BS.

Since the voltage of the clamp circuit 14 cannot rise, the clamp voltage Vclamp does not exceed the second reference voltage V2 and thus the second comparator CP2 outputs L level. This can prevent wrong detection of the power fault state.

Further, in the power fault state, since the clamp voltage becomes the voltage E, the voltage E is inputted to the non-inverting terminal of the second comparator CP2, the voltage Vclamp is inputted to the inverting terminal of the comparator CP2, and the second comparator CP2 outputs H level. This can detect the output fault state.

### (Embodiment 3)

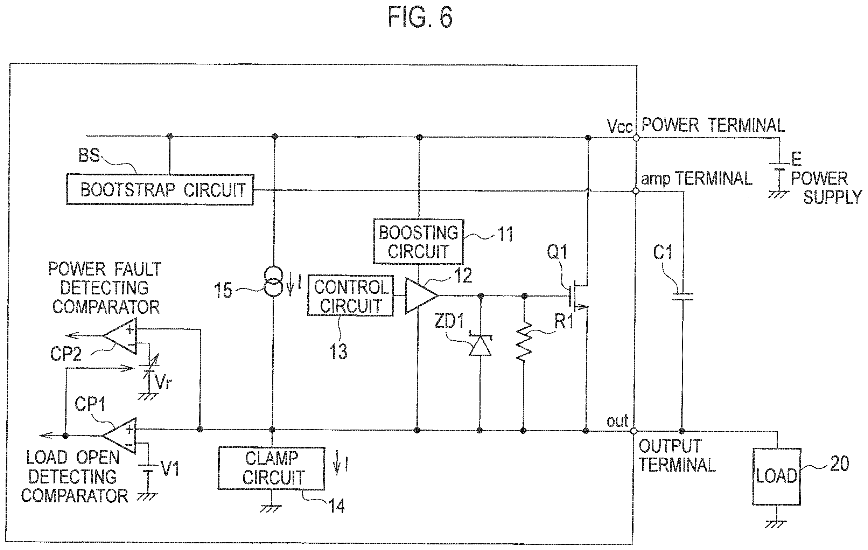

FIG. 6 is a diagram illustrating a configuration of a load driving circuit in accordance with Embodiment 3 of the present invention. The load driving circuit in accordance with Embodiment 3 is characterized by that the charging current stop circuit 16 of the load driving circuit in Embodiment 1 illustrated in FIG. 3 is not provided, and instead of this, when the first comparator CP1 detects the load open state, the second comparator CP2 sets the second reference voltage V2 to a voltage that is higher than a voltage generated by a current including a current flowing from the bootstrap circuit BS to the clamp circuit 14 via the amp terminal and the capacitor C1, and lower than the voltage E.

Other configuration is the same as that of the load driving circuit in Embodiment 1 and thus, description thereof is omitted.

The operation of the load driving circuit in accordance with Embodiment 3 will be described. The operation during normal operation and in the load open state is the same as that of the load driving circuit in Embodiment 1 and thus, only the operation in the case where the switching element Q1 is off and the first comparator CP1 detects the load open state will be described.

First, when first comparator CP1 detects the load open state, a load open state detection signal is sent from the first comparator CP1 to the second reference voltage V2 of the second comparator CP2. The second reference voltage V2 is set to a voltage that is higher than a voltage Vclamp2 generated by a current I2 including a current I1 passed from the bootstrap circuit BS to the clamp circuit 14 via the amp terminal and the capacitor C1, and lower than the voltage E, in response to the load open state detection signal. The second reference voltage V2 is preferably set according to the voltage E.

The current I2 is a sum of the current I1 flowing from the bootstrap circuit BS to the clamp circuit 14 via the amp terminal and the capacitor C1, and the current I from the constant current circuit 15. The voltage Vclamp2 generated by the current I2 is larger than the voltage Vclamp generated by the current I from the constant current circuit 15.

Since the second reference voltage V2 is the voltage that is higher than the voltage Vclamp2 and lower than the voltage E, in the non-power fault state, the clamp voltage Vclamp2 cannot exceed the second reference voltage V2 and thus, the second comparator CP2 outputs L level. This can prevent wrong detection of the power fault state

Meanwhile, in the power fault state, since the clamp voltage becomes the voltage E, the voltage E is inputted to an non-inverting terminal of the second comparator CP2, the voltage that is higher than the voltage Vclamp2 and lower than the voltage E is inputted to an inverting terminal of the comparator CP2, and the second comparator CP2 outputs H level. This can detect the power fault state.

### EXPLANATION OF SIGNS

11 A boosting circuit
12 A buffer circuit
13 A control circuit
14 A clamp circuit
15 A constant current circuit
16 A charging current stop circuit
17 A discharge stop circuit
20 A load
BSA bootstrap circuit
Q1A switching element
EA power supply
C1 A capacitor
Vcc A power terminal
OUT An output terminal
CP1 A first comparator
CP2 A second comparator

## Claims

1. A load driving circuit comprising:
a first terminal (Vcc) connected to a power supply (E);
a second terminal (out) connected to a load (20);
a switching element (Q1) connected between the first terminal (Vcc) and the second terminal (out);
a first comparator (CP1) configured to compare a voltage of the second terminal (out) with a first reference voltage (V1) that is lower than an input voltage inputted to the first terminal (Vcc) to detect a load open state where the switching element (Q1) is off and the load is not connected to the second terminal (out);
a clamp circuit (14) configured to clamp the voltage of the second terminal (out) to a clamp voltage that is higher than the first reference voltage (V1) and lower than the input voltage, in the load open state;
a second comparator (CP2) configured to compare the voltage of the second terminal (out) with a second reference voltage (V2) that is lower than the input voltage and higher than the clamp voltage to detect a power fault state where the switching element (Q1) is off and the second terminal (out) is connected to the power supply (E);
**characterized in that** the load driving circuit further comprises a capacitor (C1) having one end connected to the second terminal (out) and another end connected to a third terminal (amp);
a bootstrap circuit (BS) configured to generate a constant voltage based on a voltage of the power supply (E) at the first terminal (Vcc), and to feed a charging current to the third terminal (amp) at the constant voltage; and
a clamp voltage rise suppressing circuit (16, 17) configured to suppress a rise in the clamp voltage of the clamp circuit (14) based on a load open state detection signal outputted from the first comparator (CP1) when the first comparator (CP1) detects the load open state.

2. The load driving circuit according to claim 1, wherein
the clamp voltage rise suppressing circuit is formed of a charging current stop circuit (16) configured to stop a current flowing from the bootstrap circuit (BS) to the clamp circuit (14) via the third terminal (amp) and the capacitor (C1) when the first comparator (CP1) detects the load open state.

3. The load driving circuit according to claim 1, wherein
the clamp voltage rise suppressing circuit is formed of a discharge stop circuit (17) configured to stop discharging of the capacitor (C1) when the first comparator (CP1) detects the load open state.

4. A load driving circuit comprising:
a first terminal (Vcc) connected to a power supply (E);
a second terminal (out) connected to a load (20);
a switching element (Q1) connected between the first terminal (Vcc) and the second terminal (out);
a first comparator (CP1) configured to compare a voltage of the second terminal (out) with a first reference voltage (V1) that is lower than an input voltage inputted to the first terminal (Vcc) to detect a load open state where the switching element (Q1) is off and the load is not connected to the second terminal;
a clamp circuit (14) configured to clamp the voltage of the second terminal (out) to a clamp voltage that is higher than the first reference voltage (V1) and lower than the input voltage, in the load open state;
a second comparator (CP2) configured to compare the voltage of the second terminal (out) with a second reference voltage (V2) that is lower than the input voltage and higher than the clamp voltage to detect a power fault state;
**characterized in that** the load driving circuit further comprises a capacitor (C1) having one end connected to the second terminal (out) and another end connected to a third terminal (amp);
a bootstrap circuit (BS) configured to generate a constant voltage based on a voltage of the power supply (E) at the first terminal, and to feed a charging current to the third terminal (amp) at the constant voltage,
wherein, when the first comparator detects the load open state, the second comparator (CP2) sets the second reference voltage to a voltage that is higher than a voltage generated by a current including a current flowing from the bootstrap circuit (BS) to the clamp circuit (14) via the third terminal (amp) and the capacitor (C1), and lower than the input voltage based on a load open state detection signal outputted from the first comparator (CP1).

## Patentansprüche

1. Lasttreiberschaltung, umfassend:
ein erstes Endgerät (Vcc), das mit einer Stromversorgung (E) verbunden ist;
ein zweites Endgerät (out), das mit einer Last (20) verbunden ist;
ein Schaltelement (Q1), das zwischen dem ersten Endgerät (Vcc) und dem zweiten Endgerät (out) angeschlossen ist;
einen ersten Komparator (CP1), der dazu konfiguriert ist, eine Spannung des zweiten Endgeräts (out) mit einer ersten Referenzspannung (V1) zu vergleichen, die niedriger als eine Eingangsspannung ist, die in das erste Endgerät (Vcc) eingegeben wird, um einen offenen Lastzustand zu ermitteln, in dem das Schaltelement (Q1) ausgeschaltet ist und die Last nicht mit dem zweiten Endgerät (out) verbunden ist;
eine Klemmschaltung (14), die dazu konfiguriert ist, die Spannung des zweiten Endgeräts (out) auf eine Klemmspannung, die höher als die erste Referenzspannung (V1) und niedriger als die Eingangsspannung ist, in dem offenen Lastzustand zu klemmen;
einen zweiten Komparator (CP2), der dazu konfiguriert ist, die Spannung des zweiten Endgeräts (out) mit einer zweiten Referenzspannung (V2) zu vergleichen, die niedriger als die Eingangsspannung und höher als die Klemmspannung ist, um einen Stromfehlerzustand zu ermitteln, in dem das Schaltelement (Q1) ausgeschaltet ist und das zweite Endgerät (out) mit der Stromversorgung (E) verbunden ist;
**dadurch gekennzeichnet, dass** die Lasttreiberschaltung des Weiteren einen Kondensator (C1) umfasst, dessen eines Ende mit dem zweiten Endgerät (out) verbunden ist und dessen anderes Ende mit einem dritten Endgerät (amp) verbunden ist;
eine Bootstrap-Schaltung (BS), die dazu konfiguriert ist, eine konstante Spannung basierend auf einer Spannung der Stromversorgung (E) an dem ersten Endgerät (Vcc) zu erzeugen und einen Ladestrom zu dem dritten Endgerät (amp) auf der konstanten Spannung zu leiten; und
eine Klemmspannungs-Anstiegsunterdrückungsschaltung (16, 17), die dazu konfiguriert ist, einen Anstieg in der Klemmspannung der Klemmschaltung (14) basierend auf einem offenen Lastzustands-Ermittlungssignal zu unterdrücken, das von dem ersten Komparator (CP1) ausgegeben wird, wenn der erste Komparator (CP1) den offenen Lastzustand ermittelt.

2. Lasttreiberschaltung nach Anspruch 1, wobei
die Klemmspannungs-Anstiegsunterdrückungsschaltung aus einer Ladestrom-Stoppschaltung (16) besteht, die dazu konfiguriert ist, einen Strom, der von der Bootstrap-Schaltung (BS) zu der Klemmschaltung (14) über das dritte Endgerät (amp) und den Kondensator (C1) fließt, zu stoppen, wenn der erste Komparator (CP1) den offenen Lastzustand ermittelt.

3. Lasttreiberschaltung nach Anspruch 1, wobei
die Klemmspannungs-Anstiegsunterdrückungsschaltung aus einer Entladungsstoppschaltung (17) besteht, die dazu konfiguriert ist, die Entladung des Kondensators (C1) zu stoppen, wenn der erste Komparator (CP1) den offenen Lastzustand ermittelt.

4. Lasttreiberschaltung, umfassend:
ein erstes Endgerät (Vcc), das mit einer Stromversorgung (E) verbunden ist;
ein zweites Endgerät (out), das mit einer Last (20) verbunden ist;
ein Schaltelement (Q1), das zwischen dem ersten Endgerät (Vcc) und dem zweiten Endgerät (out) angeschlossen ist;
einen ersten Komparator (CP1), der dazu konfiguriert ist, eine Spannung des zweiten Endgeräts (out) mit einer ersten Referenzspannung (V1) zu vergleichen, die niedriger als eine Eingangsspannung ist, die in das erste Endgerät (Vcc) eingegeben wird, um einen offenen Lastzustand zu ermitteln, in dem das Schaltelement (Q1) ausgeschaltet ist und die Last nicht mit dem zweiten Endgerät verbunden ist;
eine Klemmschaltung (14), die dazu konfiguriert ist, die Spannung des zweiten Endgeräts (out) auf eine Klemmspannung, die höher als die erste Referenzspannung (V1) und niedriger als die Eingangsspannung ist, in dem offenen Lastzustand zu klemmen;
einen zweiten Komparator (CP2), der dazu konfiguriert ist, die Spannung des zweiten Endgeräts (out) mit einer zweiten Referenzspannung (V2) zu vergleichen, die niedriger als die Eingangsspannung und höher als die Klemmspannung ist, um einen Stromfehlerzustand zu ermitteln;
**dadurch gekennzeichnet, dass** die Lasttreiberschaltung des Weiteren einen Kondensator (C1) umfasst, dessen eines Ende mit dem zweiten Endgerät (out) verbunden ist und dessen anderes Ende mit einem dritten Endgerät (amp) verbunden ist;
eine Bootstrap-Schaltung (BS), die dazu konfiguriert ist, eine konstante Spannung basierend auf einer Spannung der Stromversorgung (E) an dem ersten Endgerät zu erzeugen und einen Ladestrom zu dem dritten Endgerät (amp) auf der konstanten Spannung zu leiten;
wobei, wenn der erste Komparator den offenen Lastzustand ermittelt, der zweite Komparator (CP2) die zweite Referenzspannung auf eine Spannung setzt, die höher als eine Spannung ist, die von einem Strom einschließlich eines Stroms erzeugt wird, der von der Bootstrap-Schaltung (BS) zu der Klemmschaltung (14) über das dritte Endgerät (amp) und den Kondensator (C1) fließt, und niedriger als die Eingangsspannung, basierend auf einem offenen Lastzustands-Ermittlungssignal, das von den ersten Komparator (CP1) ausgegeben wird.

## Revendications

1. Circuit de commande de charge comprenant :
une première borne (Vcc) connectée à une alimentation (E) ;
une deuxième borne (out) connectée à une charge (20) ;
un élément de commutation (Q1) connecté entre la première borne (Vcc) et la deuxième borne (out) ;
un premier comparateur (CP1) configuré pour comparer une tension de la deuxième borne (out) à une première tension de référence (V1) qui est inférieure à une tension d'entrée appliquée à la première borne (Vcc) pour détecter un état à charge ouverte où l'élément de commutation (Q1) est coupé et où la charge n'est pas connectée à la deuxième borne (out) ;
un circuit de verrouillage (14) configuré pour verrouiller la tension de la deuxième borne (out) à une tension de verrouillage qui est supérieure à la première tension de référence (V1) et inférieure à la tension d'entrée, dans l'état à charge ouverte ;
un deuxième comparateur (CP2) configuré pour comparer la tension de la deuxième borne (out) à une deuxième tension de référence (V2) qui est inférieure à la tension d'entrée et supérieure à la tension de verrouillage pour détecter un état de défaut d'alimentation où l'élément de commutation (Q1) est coupé et où la deuxième borne (out) est connectée à l'alimentation (E) ;
**caractérisé en ce que** le circuit de commande de charge comprend en outre un condensateur (C1) dont une extrémité est connectée à la deuxième borne (out) et une autre extrémité est connectée à une troisième borne (amp) ;
un circuit d'amorçage (BS) configuré pour générer une tension constante sur base d'une tension de l'alimentation (E) sur la première borne (Vcc), et pour alimenter un courant de charge sur la troisième borne (amp) à la tension constante ; et
un circuit de suppression d'augmentation de tension de verrouillage (16, 17) configuré pour supprimer une augmentation de la tension de verrouillage du circuit de verrouillage (14) sur base d'un signal de détection d'état à charge ouverte envoyé par le premier comparateur (CP1) quand le premier comparateur (CP1) détecte l'état à charge ouverte.

2. Circuit de commande de charge selon la revendication 1, dans lequel
le circuit de suppression d'augmentation de tension de verrouillage est constitué d'un circuit d'arrêt de courant de charge (16) configuré pour arrêter l'écoulement d'un courant du circuit d'amorçage (BS) vers le circuit de verrouillage (14) via la troisième borne (amp) et le condensateur (C1) quand le premier comparateur (CP1) détecte l'état à charge ouverte.

3. Circuit de commande de charge selon la revendication 1, dans lequel
le circuit de suppression d'augmentation de tension de verrouillage est constitué d'un circuit d'arrêt de décharge (17) configuré pour arrêter la décharge du condensateur (C1) quand le premier comparateur (CP1) détecte l'état à charge ouverte.

4. Circuit de commande de charge comprenant :
une première borne (Vcc) connectée à une alimentation (E) ;
une deuxième borne (out) connectée à une charge (20) ;
un élément de commutation (Q1) connecté entre la première borne (Vcc) et la deuxième borne (out) ;
un premier comparateur (CP1) configuré pour comparer une tension de la deuxième borne (out) à une première tension de référence (V1) qui est inférieure à une tension d'entrée appliquée à la première borne (Vcc) pour détecter un état à charge ouverte où l'élément de commutation (Q1) est coupé et où la charge n'est pas connectée à la deuxième borne ;
un circuit de verrouillage (14) configuré pour verrouiller la tension de la deuxième borne (out) à une tension de verrouillage qui est supérieure à la première tension de référence (V1) et inférieure à la tension d'entrée, dans l'état à charge ouverte ;
un deuxième comparateur (CP2) configuré pour comparer la tension de la deuxième borne (out) à une deuxième tension de référence (V2) qui est inférieure à la tension d'entrée et supérieure à la tension de verrouillage pour détecter un état de défaut d'alimentation ;
**caractérisé en ce que** le circuit de commande de charge comprend en outre
un condensateur (C1) dont une extrémité est connectée à la deuxième borne (out) et une autre extrémité est connectée à une troisième borne (amp) ;
un circuit d'amorçage (BS) configuré pour générer une tension constante sur base d'une tension de l'alimentation (E) sur la première borne, et pour alimenter un courant de charge sur la troisième borne (amp) à la tension constante,
dans lequel, quand le premier comparateur détecte l'état à charge ouverte, le deuxième comparateur (CP2) règle la deuxième tension de référence à une tension qui est supérieure à la tension générée par un courant comprenant un courant qui s'écoule du circuit d'amorçage (BS) au circuit de verrouillage (14) via la troisième borne (amp) et le condensateur (C1), et inférieure à la tension d'entrée sur base d'un signal de détection d'état à charge ouverte envoyé par le premier comparateur (CP1).
